Europäisches Patentamt

European Patent Office

Office européen des brevets

(11) Numéro de publication : **0 452 192 B1**

(12) **FASCICULE DE BREVET EUROPEEN**

(45) Date de publication du fascicule du brevet :
**22.02.95 Bulletin 95/08**

(21) Numéro de dépôt : **91400905.5**

(22) Date de dépôt : **03.04.91**

(51) Int. Cl.⁶ : **H03F 3/54,** H03F 1/32,
H03G 3/20, H03C 3/30

(54) **Etage amplificateur à tube hyperfréquence à large bande et faible dispersivité en fréquence.**

(30) Priorité : **13.04.90 FR 9004810**

(43) Date de publication de la demande :
**16.10.91 Bulletin 91/42**

(45) Mention de la délivrance du brevet :
**22.02.95 Bulletin 95/08**

(84) Etats contractants désignés :
**DE GB IT SE**

(56) Documents cités :
**FR-A- 2 186 776**
**US-A- 2 435 601**
**US-A- 3 080 523**
**Soviet Inventions Illustrated Derwent Publications Ltd., Section Electrique Semaine 8551,A-brege Nr. 322882, U23 14 Jan. 1986 & SU-A-1162015(Itkin V.A.) 15.06.1985**

(73) Titulaire : **THOMSON-CSF**
**173, Boulevard Haussmann**
**F-75008 Paris (FR)**

(72) Inventeur : **Durand, Alain**
**THOMSON-CSF SCPI,**
**Cedex 67**
**F-92045 Paris la Défense (FR)**
Inventeur : **Rabot, Olivier**
**THOMSON-CSF SCPI,**
**Cedex 67**
**F-92045 Paris la Défense (FR)**

(74) Mandataire : **Albert, Claude et al**
**THOMSON-CSF**
**SCPI**
**B.P. 329**
**50, rue J.P. Timbaud**
**F-92402 COURBEVOIE CEDEX (FR)**

## Description

La présente invention concerne un étage amplificateur comprenant un tube hyperfréquence dans lequel un faisceau d'électrons interagit avec une onde hyperfréquence.

Classiquement, le faisceau d'électrons est accéléré par un potentiel très haute tension de cathode, typiquement de l'ordre de 40 à 70 kV.

En outre, dans les applications radar, cette tension de cathode n'est pas appliquée de façon continue mais de façon impulsionnelle, sous forme d'un créneau de tension le plus carré possible. C'est pourquoi cette tension de cathode est également désignée « tension de modulation » lorsqu'elle est produite non pas de façon continue mais par impulsions.

Une fois accélérés, on fait interagir les électrons du faisceau avec le champ produit par une onde électromagnétique hyperfréquence (l'onde à amplifier) se déplaçant dans la même direction que le faisceau et de vitesse comparable.

Pour cela, on utilise une structure à retard permettant de ralentir la vitesse de propagation de l'onde électromagnétique hyperfréquence jusqu'à atteindre une vitesse, dite « vitesse de phase », du même ordre que celle du faisceau d'électrons.

Or les structures à retard utilisées sont le plus souvent des structures présentant une certaine dispersivité en fréquence, c'est-à-dire que le taux de retard que la structure impose à l'onde électromagnétique varie avec la fréquence de cette onde.

Il en est ainsi tout particulièrement pour les structures à retard utilisées avec les amplificateurs de grande puissance, telles que les structures à retard constituées d'une série de guides d'ondes couplés, constituant ainsi une structure dite « à cavités couplées », le long de laquelle la vitesse de l'onde hyperfréquence est considérablement ralentie, le faisceau d'électrons se déplaçant alors selon l'axe longitudinal de cette structure de manière à provoquer une interaction sur toute la longueur de cette dernière.

En revanche, la vitesse des électrons du faisceau est, essentiellement, déterminée par la seule tension de cathode, de sorte que cette vitesse est quasi-constante et indépendante de la fréquence.

De la sorte, au fur et à mesure que l'on s'écarte de la fréquence centrale de fonctionnement, il apparaît un écart de vitesse croissant entre l'onde hyperfréquence et le faisceau d'électrons, qui va réduire rapidement l'efficacité de l'interaction et va donc limiter fortement la bande passante du tube.

Plus précisément, aux fréquences les plus basses de la bande de fonctionnement du tube, la vitesse de phase est élevée, de sorte que la vitesse des électrons, comparativement, est faible (la vitesse des électrons du faisceau restant néammoins toujours supérieure à la vitesse de phase, condition indispensable pour que l'interaction puisse naître). Ces derniers ne vont donc céder qu'une faible part de leur énergie cinétique à l'onde hyperfréquence, donnant un gain réduit.

En revanche, à une fréquence élevée, la vitesse de phase sera faible et, comparativement, celle des électrons du faisceau sera élevée. Ces derniers pourront donc céder une très grande fraction de leur énergie cinétique à l'onde hyperfréquence, donnant ainsi un gain élevé.

Cependant, si l'on augmente trop la fréquence, la vitesse de phase est telle que l'on sort de la plage d'interaction, le gain chutant alors très rapidement.

On voit ainsi que la bande d'amplification du tube sera déterminée par la bande pour laquelle la condition selon laquelle la vitesse des électrons est peu différente de la vitesse de phase est respectée.

On notera incidemment qu'il est nécessaire, pour qu'il y ait interaction, que ces deux vitesses soient proches, mais non exactement identiques, au quel cas aucune interaction ne pourrait naître ; c'est cette condition que l'on entendra lorsque l'on utilisera les termes tels que « vitesses proches », « vitesses voisines », « vitesses essentiellement identiques », etc. ).

Dans ces conditions, pour obtenir une bande passante élevée, il faudrait disposer de lignes propagatrices à dispersivité réduite. Mais alors, la variation de la vitesse de phase en fonction de la fréquence serait faible, le couplage entre l'onde et le faisceau serait également faible et, par voie de conséquence, il en serait de même pour la puissance de sortie.

Mais avec des structures à retard trop dispersives, la condition de synchronisme entre onde et faisceau ne serait satisfaite que sur une bande étroite, et il en serait donc de même pour la largeur de bande du tube ; en revanche, l'adaptation sur cette bande réduite étant plus facile à réaliser, le gain du tube s'en trouverait augmenté.

On voit ainsi que les performances des étages amplificateurs de l'art antérieur sont limitées par un nécessaire compromis à trouver entre puissance de sortie élevée, gain élevé et large bande passante, ces trois caractéristiques ayant jusqu'à présent été mutuellement exclusives.

L'un des buts de l'invention est de s'affranchir de ces limitations, en proposant un étage amplificateur à tube hyperfréquence qui présente à la fois une bande passante très large et une très faible variation de puissance de sortie sur toute l'étendue de cette bande passante.

L'idée de base de l'invention consiste, à cet effet, à asservir la vitesse des électrons à celle de l'onde hyperfréquence propagée afin de synchroniser, pour une large bande de fréquences, la vitesse de l'onde à celle du faisceau.

À cet effet, dans un étage amplificateur du type précité, c'est-à-dire dans lequel on fait interagir un faisceau d'électrons avec une onde hyperfréquence de fréquence variable comprise dans une plage utile donnée, la vitesse des électrons du faisceau étant déterminée par une tension de cathode appliquée au tube et l'onde hyperfréquence se propageant dans une structure à retard lui imposant une vitesse de phase proche de la vitesse du faisceau d'électrons, la présente invention propose que la tension de cathode soit une tension variable, régulée en fonction de ladite fréquence, cette tension variant avec la fréquence pour modifier la vitesse des électrons du faisceau de manière que, pour toute fréquence de ladite plage de fréquences utile, la vitesse correspondante de ces électrons reste essentiellement, mais non exactement, identique à la vitesse de phase de l'onde hyperfréquence.

De la sorte, on compense la dispersivité en fréquence de la structure à retard et on maintient ainsi essentiellement constante la puissance délivrée en sortie par le tube.

En particulier, la tension de cathode peut, essentiellement, être déterminée par la relation :

$$V_k(f) \ = \ [4\pi^2 f^2 / \beta(f)^2] \, . \, [m \, / \, 2e] \ + \ V_\xi(f),$$

$V_k(f)$ étant la tension de cathode,

f étant la fréquence de l'onde hyperfréquence,

$\beta(f)$ étant la caractéristique de dispersivité de la structure à retard,

m étant la masse de l'électron,

e étant la charge de l'électron, et

$V_\xi(f)$ étant un terme correcteur assurant une vitesse des électrons et une vitesse de phase de l'onde hyperfréquence voisines.

Les enseignements de la présente invention peuvent s'appliquer à une très grande variété de tubes.

À cet égard, un second aspect de l'invention réside dans le modulateur permettant de produire cette tension variable.

En effet, les modulateurs utilisés jusqu'à présent pour moduler les faisceaux des tubes produisaient un niveau de tension fixe et ne permettait pas de faire varier ce niveau en fonction de la fréquence, notamment d'une impulsion de tension à la suivante (radars dits « à agilité de fréquence »).

L'invention a donc également pour objet de proposer des formes de réalisation de modulateurs permettant de réaliser cette fonction (production d'une tension variable asservie) constituant le moyen général de l'invention.

En particulier, si le tube est un tube à modulation par la cathode piloté par un modulateur formant source de tension délivrant au tube une tension de cathode essentiellement constante, on peut prévoir, selon une première forme de réalisation de l'invention, des moyens réducteurs de tension permettant, de façon variable en fonction de la fréquence, de réduire la tension de cathode effectivement appliquée au tube.

Ces moyens réducteurs de tension peuvent notamment comprendre des moyens pour dériver, de façon variable en fonction de la fréquence, une fraction du courant délivré au tube par ladite source de tension, de manière à réduire, corrélativement et de façon contrôlée, la tension de cathode effectivement appliquée au tube compte tenu de la chute de tension due à l'impédance interne de ladite source de tension.

Dans ce cas, les moyens réducteurs de tension comprennent avantageusement une source de courant ajustable en fonction de la fréquence, montée en dérivation sur le circuit de cathode du tube.

Cette source de courant peut en particulier comprendre une pluralité de sources de courant élémentaires (par exemple constituées chacune d'un transistor MOS de puissance commandé en générateur de courant et monté en série avec une résistance de valeur fixe) montées en parallèle, chacun de ces sources de courant élémentaires étant sélectivement commandée en fonction de la fréquence de manière à obtenir pour l'ensemble la valeur voulue de courant dérivé.

Si, toujours dans le cas particulier d'un tube à modulation par la cathode, celui-ci est piloté par un modulateur à source de courant commandée, on peut prévoir, selon une seconde forme de réalisation de l'invention, que la source de courant commandée soit ajustable en fonction de la fréquence de manière à réduire, corrélativement et de façon contrôlée, la tension de cathode appliquée au tube.

À cet effet, la source de courant commandée ajustable en fonction de la fréquence comprend avantageusement une pluralité de sources de courant élémentaires (par exemple constituées chacune d'un transistor MOS de puissance commandé en générateur de courant) montées en parallèle, chacune de ces sources de courant élémentaires étant sélectivement commandée en fonction de la fréquence de manière à obtenir pour l'ensemble la valeur de courant correspondant à la tension de cathode voulue.

On va maintenant décrire un exemple de réalisation de l'invention, en référence aux figures annexées.

La figure 1 est une représentation schématique d'un tube à interaction entre un faisceau d'électrons et une onde hyperfréquence.

La figure 2 montre les variations de la puissance de sortie produite par un tel tube, dans le cas de l'art antérieur (courbe $C_1$) et dans le cas de l'invention (courbe $C_2$).

La figure 3 montre un exemple de caractéristique de dispersion d'un tube.

La figure 4 montre l'allure de la variation de la tension de cathode en fonction de la fréquence de l'onde à amplifier, conformément aux enseignements de l'invention.

La figure 5 montre, de façon simplifiée, la structure d'un modulateur du type à ligne à retard selon l'art antérieur.

La figure 6 est un schéma équivalent de la figure 5.

La figure 7 est une série de chronogrammes servant à expliquer le fonctionnement du modulateur de la figure 5.

La figure 8 est homologue de la figure 6, pour un modulateur selon l'invention.

La figure 9 montre un exemple de réalisation du générateur de courant variable utilisé par le modulateur de la figure 8.

La figure 10 illustre un autre type de modulateur selon l'art antérieur, du type à courant commandé.

La figure 11 est un schéma équivalent de ce même modulateur, mais réalisé conformément aux enseignements de la présente invention.

La figure 12 montre, de façon simplifiée, un mode de réalisation d'un tel modulateur à commande de courant conformément aux enseignements de la présente invention.

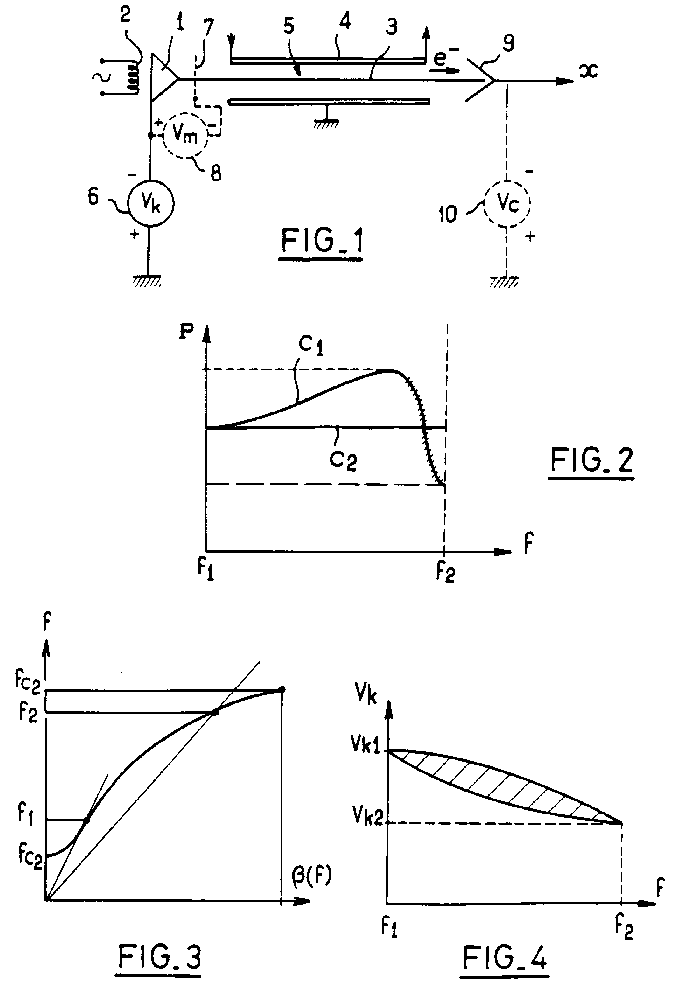

Sur la figure 1, on a représenté, de façon schématique, un tube amplificateur et ses circuits d'alimentation.

Ce tube comporte, essentiellement, une cathode 1 chauffée par un filament 2 de manière à produire des électrons par effet thermoélectronique. Ces électrons sont accélérés par application à la cathode d'une tension $V_k$, de manière à produire un faisceau homocinétique 3.

On fait alors interagir ce faisceau d'électrons 3 avec une onde électromagnétique hyperfréquence se propageant dans une structure à retard 4 (structure à cavités couplées, en hélice, à ligne en $\pi$, etc.), cette interaction ayant lieu sur toute la longueur d'un intervalle d'interaction 5 défini par la géométrie de la structure à retard 4.

La tension de cathode $V_k$ est produite par un générateur de tension 6 qui peut être, notamment dans le cas des radars, un générateur de tension impulsionnelle (ce générateur est alors appelé « modulateur ») délivrant à intervalles réguliers un créneau de tension; en variante, on peut également assurer la modulation par une grille 7 recevant une tension d'un générateur de tension de modulation $V_m$, référencé 8, polarisant la grille 7 au rythme des impulsions à produire (cette modulation étant une modulation en « tout ou rien »).

Une électrode de collecteur 9 reçoit l'énergie cinétique résiduelle des électrons après interaction, cette énergie étant soit dissipée dans le collecteur (auquel cas celui-ci est mis à la masse), soit récupérée grâce à un générateur de tension de collecteur $V_c$, référencé 10, assurant la recirculation vers la cathode 1 des charges récupérées sur le collecteur 9. On parle dans ce dernier cas de « collecteur déprimé », du fait de la mise en dépression de celui-ci par rapport au potentiel de la cathode.

On va maintenant exposer le fonctionnement d'un tel tube.

La vitesse des électrons accélérés par le potentiel de la cathode va être, de façon classique :
$$v_e = [2e/m]^{\frac{1}{2}}.[V_k]^{\frac{1}{2}}, \quad (1)$$
e étant la charge de l'électron, et
m étant la masse de l'électron.

On voit que, pour un potentiel de cathode donné, cette vitesse est constante, et totalement indépendante de la fréquence du signal hyperfréquence à amplifier se propageant le long de la ligne à retard 4.

Par ailleurs, la vitesse de phase de l'onde hyperfréquence, c'est-à-dire la vitesse de cette onde telle que ralentie par la structure à retard 4, sera de la forme :
$$v_\phi = \omega / \beta, \quad (2)$$
$\omega$ étant la pulsation temporelle de l'onde, et
$\beta$ étant le vecteur d'onde,
étant rappelé que, l'onde hyperfréquence étant une onde progressive, son amplitude A en un point du tube varie à la fois en fonction du temps $t$ et de l'abscisse $x$ du point considéré sur l'axe du tube, d'où une expression de la forme $A(t,x) = A_o \cos(\omega t - \beta x)$.

Cette relation peut également être exprimée sous la forme :
$$v_\phi = \omega / \beta(\omega) = 2\pi f / \beta(f), \quad (2bis)$$
f étant la fréquence (temporelle) de l'onde hyperfréquence considérée.

On voit que cette vitesse sera fortement dépendante de la fréquence.

En outre, le facteur $\beta(f)$, dit « caractéristique de dispersion de la structure à retard » est donné par une caractéristique de forme très complexe et variable d'un tube à l'autre, généralement non linéaire (un exemple de telle caractéristique est donné sur la figure 3).

Il va donc apparaître entre le faisceau d'électrons et l'onde hyperfréquence un écart de vitesse :

$$\Delta v = v_e - v_\phi = [2e/m]^{\frac{1}{2}}.[V_k]^{\frac{1}{2}} - 2\pi f/\beta(f), \quad (3)$$

lui-même variable (et de façon complexe, très dépendante du tube) en fonction de la fréquence.

Plus précisément, cet écart de vitesse va croître avec la fréquence, provoquant un désynchronisme croissant entre le faisceau d'électrons et l'onde hyperfréquence, avec une incidence corrélative sur la puissance de sortie, qui va augmenter dans des proportions similaires. Néanmoins, au-delà d'une certaine valeur, le désynchronisme sera tel que l'échange d'énergie entre faisceau et onde sera instable, faisant chuter brutalement le rendement d'interaction.

On obtient donc, dans les tubes tels qu'ils sont utilisés jusqu'à présent, une caractéristique de puissance de sortie telle que celle illustrée en $C_1$ sur la figure 2, présentant typiquement une grande dynamique, avec une chute brutale en haut de bande (zone hachurée sur la figure 2).

Jusqu'à présent, les générateurs ou modulateurs connus n'étaient capables, à de tels niveaux de tension et de puissance, de produire que des tensions fixes, de sorte que l'on utilisait toujours, pour un tube donné, une tension $V_k$ constante.

Au contraire, la présente invention propose, essentiellement, au lieu d'avoir une tension de cathode fixe, de faire varier celle-ci de manière à modifier corrélativement la vitesse du faisceau d'électrons afin de maintenir le synchronisme entre le faisceau d'électrons et l'onde hyperfréquence.

L'invention est applicable aussi bien au cas d'une cathode alimentée de façon continue par le potentiel $V_k$ (tube à émission continue) qu'à celui d'une cathode alimentée par des impulsions de tension de niveau $V_k$ (tube à modulation).

On verra que, dans ce dernier cas, l'invention permet de faire varier sans difficulté le niveau du potentiel de cathode, et donc de réaliser l'asservissement, d'une impulsion à la suivante, permettant ainsi d'utiliser à chaque nouvelle impulsion une fréquence différente dans la bande de fonctionnement du tube, tout en maintenant une puissance de sortie constante.

Ainsi, aux fréquences inférieures de cette bande on produira une tension de cathode plus élevée, car la vitesse de phase sera alors grande. Inversement, aux fréquences supérieures on produira une tension de cathode plus faible, car la vitesse de phase sera alors plus faible.

Ainsi, pour chacune des fréquences à amplifier, on choisira une tension de cathode permettant de réaliser pratiquement l'accord entre la vitesse de phase et celle des électrons.

Le respect de cette condition aboutit, compte tenu de la relation (3) donnée ci-dessus, à une tension de cathode $V_k(f)$ de la forme :

$$V_k(f) = [4\pi^2 f^2 / \beta(f)^2] . [m / 2e]. \quad (4)$$

En fait, comme on l'a indiqué plus haut, pour que naisse l'interaction, il est nécessaire que les vitesses, bien que très proches, ne soient pas exactement les mêmes.

On devra alors donner à la tension de cathode $V_k(f)$ une valeur de la forme :

$$V_k(f) = [4\pi^2 f^2 / \beta(f)^2] . [m / 2e] + V_\xi(f), \quad (5)$$

$V_\xi(f)$ étant un terme correcteur empêchant que la vitesse des électrons du faisceau et la vitesse de phase de l'onde hyperfréquence ne soient exactement identiques.

Un autre facteur à prendre en compte pour la détermination du terme correcteur $V_\xi(f)$ est, en particulier, l'impédance de couplage entre faisceau d'électrons et onde hyperfréquence, c'est-à-dire, en d'autres termes, l'aptitude de l'onde à recevoir de l'énergie du faisceau.

En effet, cette impédance dépend de la fréquence et, au fur et à mesure que la fréquence croît, cette impédance diminue. Pour compenser ce phénomène, on déterminera en outre $V_\xi(f)$ de manière que, essentiellement, les électrons fournissent une énergie plus élevée en haut de bande qu'en bas de bande c'est-à-dire de sorte que l'on ait, en d'autres termes, un produit impédance x rendement qui soit sensiblement constant.

On pourra également déterminer $V_\xi(f)$ de manière à compenser d'autres non-linéarités de l'étage amplificateur telles que, notamment, les variations du ROS en fonction de la fréquence lorsque l'on parcourt la bande de fonctionnement du tube.

En d'autres termes, lorsque l'on détermine la loi de variation de $V_k$ en fonction de la fréquence, on ne décrit pas exactement la caractéristique de dispersion du tube de la figure 3, mais on s'en écarte légèrement afin, d'une part, d'éviter de se trouver dans une situation de synchronisme parfait, et, d'autre part, de compenser la variation de l'impédance de couplage en fonction de la fréquence ainsi que, le cas échéant, d'autres facteurs (tels que le ROS) dépendants de la fréquence.

En ce qui concerne la limite supérieure $f_2$ de la bande d'amplification du tube, on notera que, si la fréquence augmente, comme on réduit $V_k$, on réduit également la puissance fournie au tube par l'alimentation de cathode.

En effet, cette puissance fournie $P_f$ est donnée par une expression de la forme :

$$P_f = V_k.I_k = V_k (\rho V_k^{3/2}) = \rho V_k^{5/2} \quad (6)$$

$I_k$ étant le courant de cathode, et

$\rho$ étant la « pervéance » du tube, paramètre lié à la géométrie du canon et donc inhérent au tube utilisé.

On voit que, pour une puissance hyperfréquence de sortie constante donnée, la puissance d'alimentation va diminuer très rapidement, jusqu'à une valeur limite de rendement du tube (typiquement, pour les TOPs, de l'ordre de 50 à 60%) au-dessous de laquelle on ne pourra plus produire d'amplification. Si cette fréquence limite correspondant à une fréquence $f_{C2}$, on choisira alors la valeur supérieure $f_2$ de la bande de fonctionnement de manière à rester toujours en-deçà de $f_{C2}$.

On notera néammoins que, à la différence de l'art antérieur, en haut de bande le fonctionnement du tube est particulièrement stable (c'est-à-dire qu'il est peu sensible aux variations de la puissance d'entrée hyperfréquence et de la tension $V_k$), ce qui constitue une caractéristique particulièrement avantageuse.

En ce qui concerne la valeur inférieure $f_1$ de la bande d'amplification du tube, puisque que l'on augmente $V_k$ et donc la vitesse des électrons, il est nécessaire de fournir une énergie importante au tube, et on se trouve alors dans des zones de fonctionnement dans lesquelles le rendement va décroître. En tout état de cause, il existera toujours une limite théorique constituée par la fréquence de coupure $f_{C1}$ de la structure à retard dans laquelle se propage l'onde hyperfréquence, structure qui constitue, du point de vue électrique, un filtre passe-haut.

Entre ces valeurs $f_1$ et $f_2$, on obtient une puissance de sortie telle que celle représentée par la courbe $C_2$ de la figure 2, c'est-à-dire parfaitement rectiligne (à une très faible ondulation près), ce qui permet d'avoir une très large bande passante de fonctionnement.

Ainsi, avec un émetteur de forte puissance (20 kW moyens et 1 MW crête) délivrant un signal impulsionnel hyperfréquence en bande S (2 à 4 GHz), on ne disposait auparavant en l'absence de régulation que d'une bande passante de 8% pour une variation de puissance de sortie de 1 dB alors qu'avec une régulation selon l'invention, il a été possible d'obtenir une bande passante supérieure à 20%.

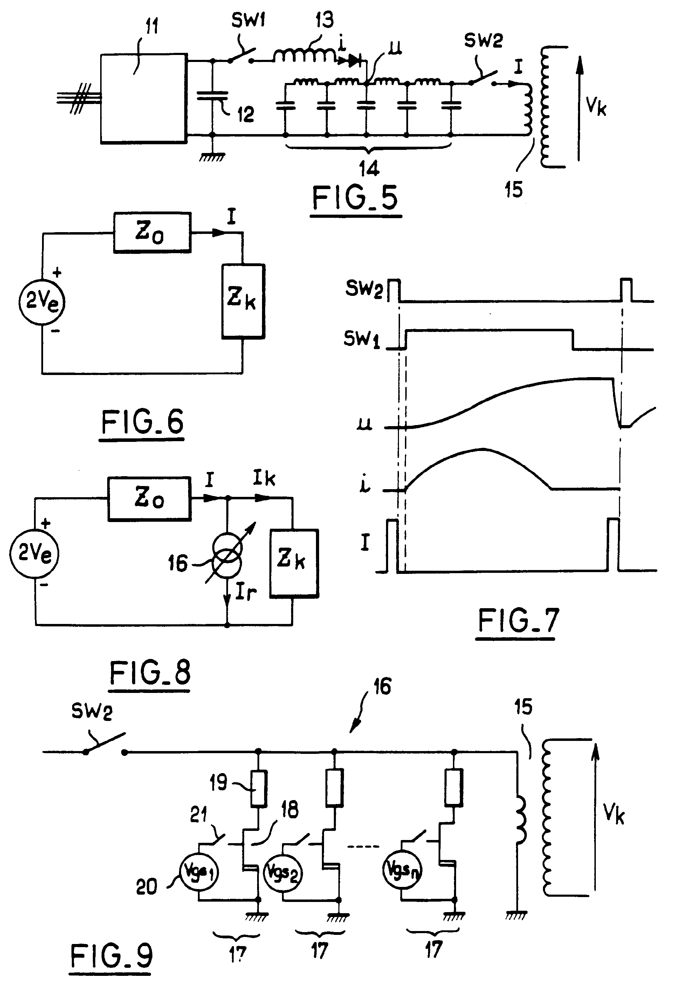

Le tube mis en oeuvre était du type TOP à ligne en $\pi$ et modulateur du type ligne à retard. La régulation était réalisée de la manière décrite plus bas en référence aux figures 8 et 9, en plaçant vingt transistors MOS en parallèle sur le primaire du transformateur d'impulsions, de manière à obtenir une tension $V_k$ variant en fonction de la fréquence d'environ 15% selon une courbe de variation telle que celle représentée figure 4.

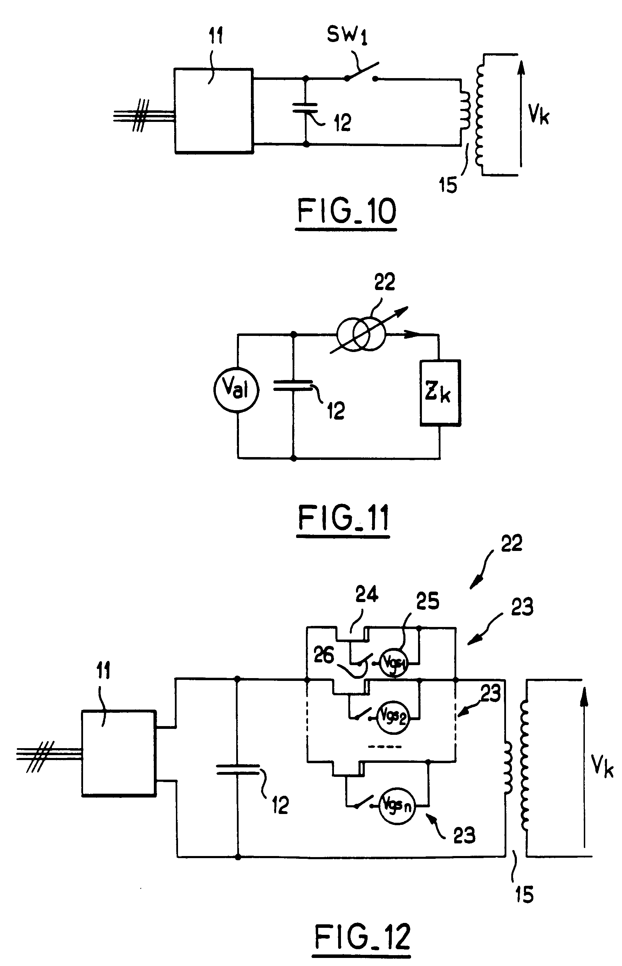

On va maintenant décrire deux exemples de réalisation d'un modulateur de tube mettant en oeuvre les enseignements de l'invention : l'un, en référence aux figures 5 à 9, correspondant à un modulateur du type à ligne à retard et l'autre, en référence aux figures 10 à 12, correspondant à un modulateur à source de courant commandée.

Dans l'un et l'autre cas, il s'agit de modulateurs utilisés pour le pilotage d'un TOP à modulation par la cathode.

On notera toutefois qu'il ne s'agit là que d'exemples particuliers de réalisation, sans aucun caractère limitatif, et que l'invention, dans son aspect le plus général, peut être appliquée à une très grande variété d'étages amplificateurs à tube, dès lors que ceux-ci utilisent l'interaction d'un faisceau d'électrons avec l'onde hyperfréquence à amplifier.

On peut notamment citer :

- tous les types de TOPs: à collecteur déprimé ou non, à collecteur simple ou multiple, à modulation par la cathode ou à modulation par la grille, à structure à retard à cavités couplées, à hélice, à ligne en $\pi$, etc.
- et également d'autres types de tubes tels que klystrons, magnétrons tubes à champs croisés, etc.

La mise en oeuvre de l'invention est également indépendante du type de modulateur utilisé (à lignes à retard, à courant commandé, etc.), et même de la présence d'un modulateur : les enseignements de l'invention peuvent en effet s'appliquer aussi bien à un tube à émission impulsionnelle qu'à un tube à émission continue.

On a représenté sur la figure 5 le schéma simplifié, en lui-même connu, d'un modulateur à retard pour tube hyperfréquence.

Un tel modulateur comporte une alimentation à découpage alimenté par le secteur triphasé, délivrant en sortie, aux bornes d'un condensateur de filtrage 12, une tension continue de l'ordre de 1000 V. Cette tension continue est appliquée, après fermeture de l'interrupteur $SW_1$ et via une inductance 13 de forte valeur, à une ligne à retard 14 constituée d'une pluralité de cellules LC montées en cascade. La sortie de la ligne peut être reliée, via un second interrupteur $SW_2$, à un transformateur d'impulsions 15 dont le secondaire délivre la tension de cathode $V_k$ (par exemple de l'ordre de 70 kV) et, éventuellement, si l'on utilise un collecteur déprimé, la tension de collecteur correspondante (par exemple, de l'ordre de 20 kV).

Dans un premier temps, on charge la ligne à retard en fermant $SW_1$ et ouvrant $SW_2$.

Du fait de la présence de l'inductance 13, dont la valeur est très supérieure à celle des inductances des cellules LC de la ligne à retard, cette dernière va en fait se comporter, essentiellement, comme une impédance

6

capacitive que l'on va charger en énergie via l'inductance 13. On obtient ainsi les courbes de courant et de tension $i$ et $u$ illustrées sur le chronogramme de la figure 7.

Une fois que la tension aux bornes de la ligne à retard 14 a atteint une valeur proche de son niveau maximal (c'est-à-dire proche de deux fois la tension délivrée par l'alimentation à découpage 11), on ouvre $SW_1$ et on ferme $SW_2$, ce qui provoque la décharge de l'énergie accumulée dans les lignes à retard 14 vers le transformateur d'impulsions 15 ; les valeurs des différents éléments étant calculées de manière que la décharge de la ligne à retard ait lieu sur une valeur égale à l'impédance caractéristique de celle-ci, on obtient une décharge impulsionnelle naturellement carrée (courbe $I$ de la figure 7), correspondant à la modulation voulue de la tension de cathode.

En pratique, on utilise plusieurs modulateurs en parallèle, avec des lignes à retard de constantes de temps différentes, afin d'optimiser le fonctionnement du modulateur.

Néanmoins, dans tous les cas, ce modulateur se comporte comme un générateur de tension fixe correspondant (schéma équivalent de la figure 6) à une source de tension $V_e$ produisant un niveau de tension fixe dont l'ordre de grandeur est le double de celui produit par la source de tension continue 11 (effet de doubleur de tension lors de la décharge de la ligne) et d'impédance propre $Z_o$, correspondant essentiellement à l'impédance propre de la ligne à retard.

Ce générateur débite la tension fixe sur une impédance $Z_k$ correspondant à l'impédance de cathode du tube vue du primaire du transformateur.

Pour mettre en oeuvre les enseignements de l'invention, il est nécessaire de modifier ce modulateur de manière à transformer la tension fixe qu'il délivre en une tension variable, commandée en fonction de la fréquence de l'onde hyperfréquence, et ceci par des moyens compatibles avec les niveaux de tension et puissance extrêmement élevés (de l'ordre de 1 kV / 1 MW crête) atteints lors de la production de cette tension de cathode.

On peut notamment, comme illustré figure 8, placer à cet effet en dérivation sur le primaire du transformateur d'impulsion 15 (c'est-à-dire en dérivation sur l'impédance $Z_k$) une source de courant commandée 16 qui dérivera une partie du courant $I$ produit par la décharge de la ligne à retard.

Dans un tel circuit, les courants et les tensions sont régis par la relation :

$$2 V_e = Z_o.I + V_k = Z_o(I_k + I_r) + V_k \quad (7)$$

$Z_0$ étant l'impédance interne de la source de tension,

$I$ étant le courant délivré par cette source de tension,

$I_k$ étant le courant de cathode, et

$I_r$ étant le courant de régulation, c'est-à-dire le courant dérivé par la source de courant ajoutée au circuit.

(on assimilera à la tension de cathode $V_k$ la tension produite par le générateur aux bornes de $Z_k$, ces deux valeurs étant peu différentes).

D'où l'on tire :

$$V_k \approx 2V_e - Z_o (I_k + I_r) = C^{te} - Z_o.I_r. \quad (8)$$

On voit ainsi, que pour obtenir une régulation de la tension de cathode ayant l'allure illustrée figure 4, on choisira en bas de bande un courant de régulation $I_r$ minimal (par exemple nul) et en haut de bande un courant de régulation maximal.

Typiquement, pour les valeurs de l'exemple mentionné plus haut, on a, pour $f = f_1$, $I_r = 0$ et $I_k = 2800$ A et, pour $f = f_2$, $I_r = 600$ A environ et $I_k = 2200$ A.

La réalisation d'un tel générateur de courant variable implique à la fois des tensions et des courants élevés (typiquement des tensions pouvant atteindre 900 V aux bornes du générateur, pour des courants compris entre 0 et 600 A).

On peut par exemple utiliser une structure telle que celle illustrée figure 9, où la source de courant 16 est formée d'une batterie de sources élémentaires 17 toutes montées en parallèle, par exemple au nombre de vingt.

Chacune de ces sources élémentaires est constituée d'un transistor MOS de puissance 18 (par exemple un transistor 1000 V 500 W et 60 A crête) en série avec une résistance 19 (afin que l'essentiel de la tension chute aux bornes de cette résistance), chacun des transistors étant commandé par une tension respective $V_{gs1} \dots V_{gsn}$ produite par une source respective 20 et appliquée sélectivement par l'intermédiaire d'un interrupteur 21.

Avec n = 20 étages semblables, on peut ainsi obtenir un générateur de courant 0-600 A par pas de 30 ampères, commandé sélectivement par activation des interrupteurs 21.

Les commutations à effectuer en fonction de la fréquence peuvent par exemple être tabulées dans une mémoire morte programmable contrôlant sélectivement la fermeture des divers interrupteurs 21 ).

Le point de fonctionnement de chacun des MOS est choisi de manière que ceux-ci fonctionnent en générateurs de courant, c'est-à-dire qu'ils laissent passer entre drain et source un courant proportionnel à la tension

$V_{gs1}$ ... $V_{gsn}$ appliquée entre grille et source.

Au lieu de prévoir des étages tous identiques, on pourrait prévoir des courants différents pour certains, ce qui permettrait d'obtenir des pas de variation plus fins, la loi de commutation étant, ici encore, tabulée dans une mémoire morte programmable indiquant les différentes commutations à effectuer en fonction de la tension $V_k$ voulue, c'est-à-dire en fonction de la fréquence de l'onde hyperfréquence.

On a illustré figures 10 à 12 une autre forme de réalisation possible, dans laquelle on utilise non plus un modulateur à ligne à retard, mais un modulateur à courant commandé.

Le schéma simplifié, connu en lui-même, d'un tel modulateur est illustré figure 10 : l'alimentation à découpage 10 délivre, ici encore, une tension continue de l'ordre de 1000 V, mais on utilise ici le condensateur de filtrage 12 pour stocker l'énergie.

Lorsque l'on souhaite appliquer le courant sur le tube, on ferme $SW_1$, ce qui produit la décharge du condensateur 12 dans le transformateur d'impulsions 15.

Pour mettre en oeuvre les enseignements de l'invention, on remplace l'interrupteur $SW_1$ par un générateur de courant variable 22, comme illustré sur le schéma équivalent de la figure 11, afin que le courant dans le primaire du transformateur 15, et donc la tension du créneau appliqué à la cathode du tube, dépendent de la fréquence.

On peut utiliser à cet effet un montage tel que celui illustré figure 12, dans lequel la source de courant variable 22 est constituée d'une batterie de sources élémentaires 23 montées en parallèle, chacune comprenant un MOS de puissance 24 dont le courant de fonctionnement est commandé par une tension $V_{gs1}$ ... $V_{gsn}$ délivrée par une source 25 de façon sélective via un commutateur 26.

Comme dans le cas de la figure 9, on peut ainsi, en choisissant une loi de commutation appropriée des divers interrupteurs 26, obtenir une variation incrémentale du courant dans le primaire du transformateur 15, et donc du niveau de tension $V_k$ délivré au secondaire de ce même transformateur, selon une loi de variation telle que celle illustrée figure 4.

## Revendications

1. Un étage amplificateur comprenant un tube hyperfréquence du type dans lequel on fait interagir un faisceau d'électrons (3) avec une onde hyperfréquence de fréquence variable comprise dans une plage utile donnée, la vitesse des électrons du faisceau étant déterminée par une tension de cathode appliquée au tube et l'onde hyperfréquence se propageant dans une structure à retard (4) lui imposant une vitesse de phase proche de la vitesse du faisceau d'électrons,

   caractérisé en ce que ladite tension de cathode est une tension variable, régulée en fonction de ladite fréquence, cette tension variant avec la fréquence pour modifier la vitesse des électrons du faisceau de manière que, pour toute fréquence de ladite plage de fréquences utile, la vitesse correspondante de ces électrons reste essentiellement, mais non exactement, identique à la vitesse de phase de l'onde hyperfréquence, de sorte que l'on compense la dispersivité en fréquence de la structure à retard et on maintient ainsi essentiellement constante la puissance délivrée en sortie par le tube.

2. L'étage amplificateur de la revendication 1, dans lequel la tension de cathode est essentiellement déterminée par la relation :
$$V_k(f) = [4\pi^2 f^2 / \beta(f)^2] \cdot [m / 2e] + V_\xi(f),$$
   $V_k(f)$ étant la tension de cathode,
   f étant la fréquence de l'onde hyperfréquence,
   $\beta(f)$ étant la caractéristique de dispersivité de la structure à retard,
   m étant la masse de l'électron,
   e étant la charge de l'électron, et
   $V_\xi(f)$ étant un terme correcteur assurant une vitesse des électrons et une vitesse de phase de l'onde hyperfréquence voisines.

3. L'étage amplificateur de la revendication 1, dans lequel, le tube étant un tube à modulation par la cathode piloté par un modulateur formant source de tension délivrant au tube une tension de cathode essentiellement constante, il est prévu des moyens réducteurs de tension permettant, de façon variable en fonction de la fréquence, de réduire la tension de cathode effectivement appliquée au tube.

4. L'étage amplificateur de la revendication 3, dans lequel lesdits moyens réducteurs de tension comprennent des moyens pour dériver, de façon variable en fonction de la fréquence, une fraction du courant délivré au tube par ladite source de tension, de manière à réduire, corrélativement et de façon contrôlée, la tension de cathode effectivement appliquée au tube compte tenu de la chute de tension due à l'impédance interne de ladite source de tension.

5. L'étage amplificateur de la revendication 4, dans lequel lesdits moyens réducteurs de tension comprennent une source de courant (16) ajustable en fonction de la fréquence, montée en dérivation sur le circuit de cathode du tube.

6. L'étage amplificateur de la revendication 5, dans lequel ladite source de courant (16) comprend une pluralité de sources de courant élémentaires (17) montées en parallèle, chacun de ces sources de courant élémentaires étant sélectivement commandée en fonction de la fréquence de manière à obtenir pour l'ensemble la valeur voulue de courant dérivé.

7. L'étage amplificateur de la revendication 6, dans lequel chacune desdites sources de courant élémentaires (17) comprend un transistor MOS de puissance (18) commandé en générateur de courant et monté en série avec une résistance (19) de valeur fixe.

8. L'étage amplificateur de la revendication 1, dans lequel, le tube étant un tube à modulation par la cathode piloté par un modulateur à source de courant commandée (22), la source de courant commandée est ajustable en fonction de la fréquence de manière à réduire, corrélativement et de façon contrôlée, la tension de cathode appliquée au tube.

9. L'étage amplificateur de la revendication 8, dans lequel ladite source de courant commandée ajustable en fonction de la fréquence (22) comprend une pluralité de sources de courant élémentaires (23) montées en parallèle, chacune de ces sources de courant élémentaires étant sélectivement commandée en fonction de la fréquence de manière à obtenir pour l'ensemble la valeur de courant correspondant à la tension de cathode voulue.

10. L'étage amplificateur de la revendication 9, dans lequel chacune desdites sources de courant élémentaires (23) comprend un transistor MOS de puissance (24) commandé en générateur de courant.


**Patentansprüche**

1. Verstärkerstufe, mit einer Höchstfrequenzröhre des Typs, in dem ein Elektronenstrahl (3) zu einer Wechselwirkung mit einer Höchstfrequenzwelle mit veränderlicher Frequenz, die in einem gegebenen Nutzbereich liegt, veranlaßt wird, wobei die Geschwindigkeit der Elektronen des Strahls durch eine an die Röhre angelegte Katodenspannung bestimmt ist und die Höchstfrequenzwelle sich in einer Verzögerungsstruktur (4) fortpflanzt, die ihr eine Phasengeschwindigkeit verleiht, die in der Nähe der Geschwindigkeit des Elektronenstrahls liegt,
dadurch gekennzeichnet, daß die Katodenspannung eine veränderliche, in Abhängigkeit von der Frequenz gesteuerte Spannung ist, die sich mit der Frequenz verändert, um die Geschwindigkeit der Elektronen des Strahls in der Weise zu verändern, daß für jede Frequenz des Nutz-Frequenzbereichs die entsprechende Geschwindigkeit dieser Elektronen im wesentlichen, jedoch nicht genau gleich der Phasengeschwindigkeit der Höchstfrequenzwelle bleibt,
derart, daß die Frequenzdispersität der Verzögerungsstruktur kompensiert wird und somit die am Ausgang der Röhre abgegebene Leistung im wesentlichen konstant gehalten wird.

2. Verstärkerstufe nach Anspruch 1, in der die Katodenspannung im wesentlichen durch die Beziehung bestimmt ist:

$$V_k(f) = \left[4\pi^2 f^2 / \beta(f)^2\right] \cdot \left[m/2e\right] + V_\xi(f)$$

wobei
$V_k(f)$ die Katodenspannung ist,
f die Frequenz der Höchstfrequenzwelle ist,
$\beta(f)$ die Dispersitätscharakteristik der Verzögerungsstruktur ist,
m die Elektronenmasse ist,

e die Elektronenladung ist und

V$\xi$(f) ein Korrekturterm ist, der eine Geschwindigkeit der Elektronen und eine Phasengeschwindigkeit der Höchstfrequenzwelle gewährleistet, die einander benachbart sind.

3. Verstärkerstufe nach Anspruch 1, in der dann, wenn die Röhre eine katodenmodulierte Röhre ist, die durch einen eine Spannungsquelle bildenden Modulator gesteuert wird, der an die Röhre eine im wesentlichen konstante Katodenspannung anlegt, Spannungsreduzierungsmittel vorgesehen sind, die auf veränderliche Weise in Abhängigkeit von der Frequenz die Reduzierung der an die Röhre effektiv angelegten Katodenspannung ermöglichen.

4. Verstärkerstufe nach Anspruch 3, in der die Spannungsreduzierungsmittel Mittel enthalten, die auf veränderliche Weise in Abhängigkeit von der Frequenz einen Anteil des durch die Spannungsquelle zur Röhre gelieferten Stroms ableiten, derart, daß die an die Röhre effektiv angelegte Katodenspannung bei Berücksichtigung des Spannungsabfalls aufgrund der internen Impedanz der Spannungsquelle korrelativ und auf gesteuerte Weise reduziert wird.

5. Verstärkerstufe nach Anspruch 4, in der die Spannungsreduzierungsmittel eine Stromquelle (16) enthalten, die in Abhängigkeit von der Frequenz einstellbar ist und an die Katodenschaltung der Röhre im Nebenschluß angeschaltet ist.

6. Verstärkerstufe nach Anspruch 5, in der die Stromquelle (16) mehrere parallelgeschaltete elementare Stromquellen (17) umfaßt, wobei jede dieser elementaren Stromquellen in Abhängigkeit von der Frequenz selektiv gesteuert wird, um auf diese Weise insgesamt den gewünschten Wert des abgeleiteten Stroms zu erhalten.

7. Verstärkerstufe nach Anspruch 6, in der jede der elementaren Stromquellen (17) einen Leistungs-MOS-Transistor (18) enthält, der als Stromgenerator gesteuert wird und mit einem Widerstand (19) mit festem Wert in Serie geschaltet ist.

8. Verstärkerstufe nach Anspruch 1, in der dann, wenn die Röhre eine katodenmodulierte Röhre ist, die durch einen Modulator mit gesteuerter Stromquelle (22) gesteuert wird, die gesteuerte Stromquelle in Abhängigkeit von der Frequenz in der Weise einstellbar ist, daß die an die Röhre angelegte Katodenspannung korrelativ und auf gesteuerte Weise reduziert wird.

9. Verstärkerstufe nach Anspruch 8, in der die gesteuerte Stromquelle, die in Abhängigkeit von der Frequenz (22) einstellbar ist, mehrere parallelgeschaltete elementare Stromquellen umfaßt, wobei jede dieser elementaren Stromquellen in Abhängigkeit von der Frequenz selektiv gesteuert wird, um auf diese Weise insgesamt den der gewünschten Katodenspannung entsprechenden Stromwert zu erhalten.

10. Verstärkerstufe nach Anspruch 9, in der jede der elementaren Stromquellen (23) einen als Stromgenerator gesteuerten Leistungs-MOS-Transistor (24) enthält.

## Claims

1. An amplifier stage comprising a UHF tube of the type in which a beam of electrons (3) is made to interact with a variable-frequency UHF wave lying in a given useful range, the speed of the electrons of the beam being determined by a cathode voltage applied to the tube, and the UHF wave propagating in a delay structure (4) imposing on it a phase speed close to the speed of the beam of electrons,

characterized in that the said cathode voltage is a variable voltage, regulated as a function of the said frequency, this voltage varying with the frequency in order to modify the speed of the electrons of the beam in such a way that, for any frequency of the said useful frequency range, the corresponding speed of these electrons remains essentially, but not exactly, identical to the phase speed of the UHF wave,

in such a way that the frequency-dispersivity of the delay structure is compensated for, and thus the output power delivered by the tube is kept essentially constant.

2. The amplifier stage of Claim 1, in which the cathode voltage is determined essentially by the relationship:
$$V_k(f) \ = \ [4\pi^2 f^2 / \beta(f)^2] \ . \ [m / 2e] \ + \ V_\zeta(f),$$

$V_k(f)$ being the cathode voltage,

f being the frequency of the UHF wave,

$\beta(f)$ being the dispersivity characteristic of the delay structure,

m being the mass of the electron,

e being the charge on the electron, and

$V_\zeta(f)$ being a corrector term ensuring that the

speed of the electrons and the phase speed of the UHF wave are close.

3. The amplifier stage of Claim 1, in which, with the tube being cathode-modulated tube driven by a modulator forming a voltage source, delivering an essentially constant cathode voltage to the tube, voltage reducing means are provided making it possible, in a way which is variable as a function of frequency, to reduce the cathode voltage actually applied to the tube.

4. The amplifier stage of Claim 3, in which the said voltage-reducing means comprise means for tapping off, in a way which is variable as a function of frequency, a fraction of the current delivered to the tube by the said voltage source, in such a way as to reduce the cathode voltage actually applied to the tube, correspondingly and in a controlled way, having regard to the voltage drop due to the internal impedance of the said voltage source.

5. The amplifier stage of Claim 4, in which the said voltage-reducing means comprise a current source (16) which is adjustable as a function of frequency, mounted in parallel with the cathode circuit of the tube.

6. The amplifier stage of Claim 5, in which the said current source (16) comprises a plurality of elementary current sources (17) mounted in parallel, each of these elementary current sources being controlled selectively as a function of frequency in such a way as to obtain the desired value of tapped-off current overall.

7. The amplifier stage of Claim 6, in which each of the said elementary current sources (17) comprises a power MOS transistor (18) controlled as a current generator and mounted in series with a fixed-value resistor (19).

8. The amplifier stage of Claim 1, in which, with the tube being a cathode-modulated tube driven by a controlled current-source modulator (22), the controlled current source is adjustable as a function of frequency in such a way as to reduce the cathode voltage applied to the tube, correspondingly and in a controlled way.

9. The amplifier stage of Claim 8, in which the said controlled current source which is adjustable as a function of frequency (22) comprises a plurality of elementary current sources (23) mounted in parallel, each of these elementary current sources being selectively controlled as a function of frequency in such a way as to obtain the overall current value corresponding to the desired cathode voltage.

10. The amplifier stage of Claim 9, in which each of the said elementary current sources (23) comprises a power MOS transistor (24) controlled as a current generator.

FIG.1

FIG.2

FIG.3

FIG.4

FIG.5

FIG.6

FIG.8

FIG.7

FIG.9

FIG.10

FIG.11

FIG.12